# EUROPÄISCHE PATENTSCHRIFT

(11) **EP 1 307 927 B1**
(45) Veröffentlichungstag und Bekanntmachung des Hinweises auf die Patenterteilung: **22.09.2010**
(21) Anmeldenummer: 01964845.0
(22) Anmeldetag: 24.07.2001
(51) Int. Cl.: H01L 33/20

(54) **STRAHLUNGSEMITTIERENDER HALBLEITERCHIP UND LUMINESZENZDIODE**
RADIATION-EMITTING SEMICONDUCTOR CHIP AND LUMINESCENT DIODE
PUCE SEMI-CONDUCTRICE EMETTANT UN RAYONNEMENT ET DIODE ELECTROLUMINESCENTE

(30) Priorität: 11.08.2000 DE 10039433
(43) Veröffentlichungstag der Anmeldung: 07.05.2003
(73) Patentinhaber: OSRAM Opto Semiconductors GmbH, 93055 Regensburg (DE)
(72) Erfinder: BAUR, Johannes, 93180 Deuerling (DE); EISERT, Dominik, 93049 Regensburg (DE); FEHRER, Michael, 93077 Bad Abbach (DE); HAHN, Berthold, 93155 Hemau (DE); HÄRLE, Volker, 93164 Waldetzenberg (DE); JACOB, Ulrich, 93053 Regensburg (DE); PLASS, Werner, 93047 Regensburg (DE); STRAUSS, UWE, 93077 Bad Abbach (DE); VÖLKL, Johannes, 91056 Erlangen (DE); ZEHNDER, Ulrich, 93049 Regensburg (DE)
(74) Vertreter: Epping - Hermann - Fischer
(86) Internationale Anmeldenummer: PCT/DE2001/002801
(87) Internationale Veröffentlichungsnummer: WO 2002/015287

(56) Entgegenhaltungen:
- EP-A- 0 544 512
- EP-A- 0 905 797
- EP-A- 0 961 328
- JP-A- 49 040 092
- JP-A- 49 090 494
- US-A- 3 576 586
- US-A- 5 631 474
- US-A- 5 990 497
- PATENT ABSTRACTS OF JAPAN vol. 008, no. 084 (E-239), 18. April 1984 (1984-04-18) & JP 59 004088 A (TOKYO SHIBAURA DENKI), 10. Januar 1984 (1984-01-10)
- PATENT ABSTRACTS OF JAPAN vol. 1997, no. 03, 31. März 1997 (1997-03-31) -& JP 08 288543 A (RICOH CO LTD), 1. November 1996 (1996-11-01)
- PATENT ABSTRACTS OF JAPAN vol. 018, no. 590 (E-1628), 10. November 1994 (1994-11-10) -& JP 06 224469 A (KYOCERA CORP), 12. August 1994 (1994-08-12)
- PATENT ABSTRACTS OF JAPAN vol. 017, no. 676 (E-1475), 13. Dezember 1993 (1993-12-13) -& JP 05 226781 A (FUJITSU LTD), 3. September 1993 (1993-09-03)
- PATENT ABSTRACTS OF JAPAN vol. 011, no. 294 (E-544), 22. September 1987 (1987-09-22) & JP 62 093985 A (KANEGAFUCHI CHEM IND), 30. April 1987 (1987-04-30)
- PATENT ABSTRACTS OF JAPAN vol. 2000, no. 02, 29. Februar 2000 (2000-02-29) -& JP 11 317546 A (MATSUSHITA ELECTR CO), 16. November 1999 (1999-11-16)
- PATENT ABSTRACTS OF JAPAN vol. 1996, no. 08, 30. August 1996 (1996-08-30) & JP 08 102549 A (ROHM CO LTD), 16. April 1996 (1996-04-16)

## Beschreibung

Die Erfindung betrifft einen strahlungsemittierenden Halbleiterchip mit einer aktiven Schicht, die eine strahlungserzeugende Zone umfaßt, und mit Querseiten und Längsseiten, die die den Halbleiter in eine Erstreckungsrichtung der aktiven Zone seitlich begrenzen. Weiterhin betrifft die Erfindung eine mit einem solchen Halbleiterchip gebildete Lumineszenzdiode.

Ein derartiger Halbleiterchip ist aus dem Artikel von Song Jae Lee und Seok Won Song "Efficiency Improvement in Light-Emitting Diodes Based on Geometrically Deformed Chips", SPIE Conference on Light-Emitting Diodes: Research, Manufacturing and Applications III, San José, Kalifornien, Januar 1999, Seiten 237-248, bekannt. Der Halbleiterkörper eines dort beschriebenen Halbleiterchips weist eine untere Deckschicht, eine aktive Zone und eine obere Deckschicht auf. In einer Ausführungsform ist der Halbleiterchip prismenförmig mit einer Raute als Grundfläche ausgebildet. Bei einem solchen rautenförmigen Grundriß treffen die von der aktiven Zone ausgehenden Lichtstrahlen zumindest nach einigen Totalreflexionen an den Seitenflächen auf eine Seitenfläche unter einem Winkel auf, der kleiner als der Grenzwinkel für die Totalreflexion ist. Die Lichtausbeute ist im wesentlichen durch die Absorption im Halbleiterchip begrenzt.

Aus der Druckschrift US 5,990,497 ist ein strahlungsemittierender Halbleiterchip mit einem GaAs-Substrat bekannt, der eine rechteckige Strahlungsaustrittsfläche aufweist.

Aus der Druckschrift EP 0 961 328 A2 sind auf GaN basierende Halbleiterchips bekannt, welche unter anderem die Form eines Parallelogramms aufweisen.

Schwierigkeiten mit den bekannten Halbleiterchips ergeben sich bei deren Anwendung für hohe Lichtleistungen. Denn hohe Lichtleistungen setzen große elektrische Ströme durch den Halbleiterchip voraus. Dabei besteht ein nichtlinearer Zusammenhang zwischen Lichtleistung und erforderlicher Stromstärke. Die erforderliche Stromstärke steigt nämlich überproportional mit der Lichtleistung an. Die pro Flächeneinheit der Querschnittsfläche erzeugte Wärme steigt daher mit zunehmender Lichtleistung des Halbleiterchips überproportional an. Um die thermische Belastung zu begrenzen, ist es daher notwendig, die Stromdichte durch Vergrößern der Querschnittsfläche zu senken. Infolgedessen weisen Halbleiterchips mit hoher Lichtleistung im allgemeinen besonders große Querschnittsflächen auf.

Bei gleichbleibender Dicke des Halbleiterchips hat dies jedoch zur Folge, daß die Seitenflächen des Halbleiterchips von einem Licht erzeugenden Leuchtpunkt der aktiven Zone aus gesehen unter einem kleineren Raumwinkel erscheinen. Prozentual gesehen treffen daher weniger Lichtstrahlen unmittelbar auf die Seitenflächen des Halbleiterchips auf. Zwar kann dies grundsätzlich dadurch behoben werden, daß die Dicke des Halbleiterchips mit den Querschnittsabmessungen skaliert wird, denn dadurch würden sich wieder große Seitenflächen ergeben. Dies ist aber aus verfahrenstechnischen Gründen schwer möglich. Außerdem sind beispielsweise Substrate nur mit bestimmten vorgegebenen Schichtdicken im Handel erhältlich.

Ausgehend von diesem Stand der Technik liegt der Erfindung die Aufgabe zugrunde, einen für hohe Strahlungsleistungen geeigneten Halbleiterchip mit verbesserter Auskopplung der im Halbleiterchip erzeugten Strahlung zu schaffen. Weiterhin ist es Aufgabe der Erfindung, ein optisches Bauelement mit verbesserter Strahlungsausbeute anzugeben.

Diese Aufgabe wird erfindungsgemäß dadurch gelöst, daß die Querseiten des Halbleiterchips in Erstreckungsrichtung der aktiven Zone kürzer als die Längsseiten sind, wobei die Querseiten wenigstens derart kurz sind, dass die von einem von einer Längsseite am weitesten entfernt liegenden Leuchtpunkt der aktiven Schicht ausgehenden Lichtstrahlen unmittelbar unter einem Winkel kleiner als der Totalreflexionswinkel auf diese Längsseite treffen.

Um einen für hohe Lichtleistungen geeigneten Halbleiterchip zu erhalten, ist zunächst erforderlich, den lateralen Querschnitt so groß zu wählen, daß die erzeugte Verlustwärme abgeführt werden kann. Unter dem lateralen Querschnitt ist die Fläche eines sich längs zu der aktiven Zone erstreckenden Querschnitts zu verstehen. Insbesondere in einem Material mit geringer Wärmeleitfähigkeit ist der laterale Querschnitt so groß zu wählen, daß die in der aktiven Zone entstehende Verlustwärme abgeführt werden kann. Durch die Verlängerung der Längsseiten bezüglich der Querseiten läßt sich nun das Verhältnis von Querschnittsfläche zu der Summe der Seitenflächen beeinflussen. Insbesondere läßt sich das Verhältnis von Querschnittsfläche zu der Summe der Seitenflächen durch die Verlängerung der Längsseiten bezüglich der Querseiten senken. Dadurch wird das Verhältnis von Querschnittsfläche zu der Summe der Seitenflächen für die Lichtauskopplung wesentlich günstiger. Folglich erscheinen die Längsseiten im Vergleich zu dem Fall, in dem die Längsseiten und Querseiten gleichmäßig verlängert werden, von der aktiven Zone aus gesehen unter einem größeren Raumwinkel. Der prozentuale Anteil der Strahlung, der unmittelbar auf eine Seitenfläche trifft, ist daher höher. Die optischen Wege, die die Strahlung im Halbleiterchip durchläuft, werden deshalb auch kürzer. Die Wahrscheinlichkeit, daß Strahlungsanteile auf dem Weg zu einer Seitenfläche absorbiert werden, ist daher kleiner.

Aus diesen Gründen weist ein Halbleiterchip, dessen Längsseiten bezüglich der Querseiten länger sind, bei gleicher Querschnittsfläche eine bessere Strahlungsausbeute auf als ein Halbleiterchip mit gleich langen Seiten.

Bei einer bevorzugten Ausführungsform befindet sich die aktive Zone in einer aktiven Schicht, die auf einem strahlungsdurchlässigen Substrat angeordnet ist, das sich zu einer der aktiven Schicht gegenüberliegenden Grundfläche des Substrates hin verjüngt.

Da die von der aktiven Schicht ausgehende Strahlung, die das strahlungsdurchlässige Substrat durchläuft, im allgemeinen an den abgeschrägten Längsseiten unter einem Winkel auftrifft, der kleiner als der Totalreflexionswinkel ist, führt eine Vergrößerung des Raumwinkels, unter dem die Seitenflächen von der aktiven Schicht aus gesehen erscheinen, zu einer besonders hohen Lichtausbeute.

Weitere vorteilhafte Ausgestaltungen der Erfindung sind Gegenstand der abhängigen Ansprüche.

Nachfolgend wird die Erfindung im einzelnen anhand der beigefügten Zeichnung erläutert. Es zeigen:
- Figur 1a und b: eine schematische Darstellung eines Quer- schnitts und eines Längsschnitt durch ei- nen Halbleiterchip gemäß der Erfindung,
- Figur 2a und b: eine schematische Darstellung eines Quer- schnitts durch eine Lumineszenzdiode und einer Aufsicht auf eine Lumineszenzdiode, die mit dem Halbleiterchip aus den Figu- ren 1a und b ausgestattet ist,
- Figur 3a und b: eine schematische Darstellung eines Quer- schnitts durch eine weitere Lumineszenz- diode und einer Aufsicht auf eine weitere Lumineszenzdiode, die mit dem Halbleiter- chip aus den Figuren 1a und b versehen ist,
- Figur 4: eine schematische Darstellung einer ver- größerte Aufsicht auf einen mit einer Kontaktschicht versehenen Halbleiterchip,
- Figur 5: eine schematische Darstellung eines Quer- schnitts durch einen weiteren Halbleiter- chip,
- Figur 6: eine schematische Darstellung eines Quer- schnitts durch einen abgewandelten Halb- leiterchip und
- Figur 7: eine schematische Darstellung eines Quer- schnitts durch ein weiteres abgewandeltes Ausführungsbeispiel des Halbleiterchips.

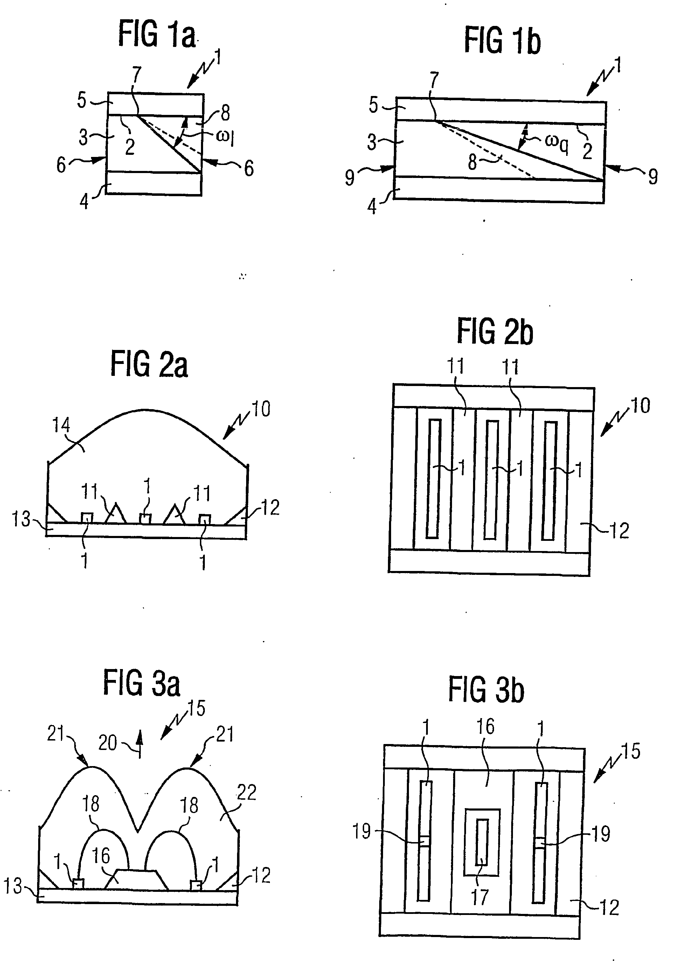

Figur 1a zeigt einen Querschnitt durch einen Halbleiterchip 1, der über eine aktive Schicht 2 verfügt. Die aktive Schicht 2 ist im allgemeinen eine eine strahlungsemittierende Zone enthaltende stromführende Schicht oder Schichtenfolge, vorzugsweise innerhalb einer Mehrschichtstruktur. Die aktive Schicht 2 ist auf einem Substrat 3 angeordnet, das für die Strahlung aus der aktiven Schicht 2 durchlässig ist. Weiter sind eine untere Abdeckschicht 4 und eine obere Abdeckschicht 5 vorhanden, die beispielsweise als Kontaktschichten dienen. Ferner verfügt der Halbleiterchip 1 über Längsseiten 6.

Im allgemeinen ist das Substrat von einem Medium umgeben, das einen geringeren Brechungsindex als das Substrat aufweist. Aufgrund von Totalreflexion an den Substratseitenflächen, beispielsweise die Längsseiten 6 in Figur 1a, können durch die Seitenflächen nur diejenigen Lichtstrahlen aus dem Substrat austreten, die auf die Seitenflächen unter einem Winkel auftreffen, der kleiner als der Grenzwinkel der Totalreflexion für den Übergang vom Substrat in das angrenzende Medium ist. Dieser Winkel wird im folgenden auch kurz als Totalreflexionswinkel bezeichnet.

Für eine Auskopplung an einer Substratseitenfläche müssen daher die von einem Leuchtpunkt ausgehenden Lichtstrahlen innerhalb eines Lichtaustrittskegels verlaufen, dessen Mittelachse die durch den Leuchtpunkt verlaufende Flächennormale der Substratseitenfläche ist. Der Öffnungswinkel des Lichtaustrittskegels ist doppelt so groß wie der Totalreflexionswinkel. Verlaufen die von dem Leuchtpunkt ausgehenden Lichtstrahlen außerhalb dieses Lichtaustrittskegels, so werden sie an der betreffenden Substratseitenfläche totalreflektiert.

Bei dem in Figur 1a dargestellten Fall erscheint der vom Substrat 3 gebildete Bereich der Längsseiten 6 von einem Strahlung aussendenden Leuchtpunkt 7 der aktiven Schicht 2 aus unter einem Raumwinkel ω₁. Dieser Raumwinkel ω₁ ist so groß, daß alle vom Leuchtpunkt 7 ausgehenden und innerhalb des im Substrat 3 liegenden Anteils des Lichtaustrittskegels 8 verlaufenden Lichtstrahlen auf die Längsseite 6 treffen und ausgekoppelt werden.

In Figur 1b ist der Halbleiterchip 1 im Längsschnitt dargestellt. Vom Leuchtpunkt 7 aus erscheinen die vom Substrat 3 gebildeten Bereiche der Querseiten 9 unter einem Raumwinkel ω_{q.} Der Raumwinkel ω_{q} ist wesentlich kleiner als der Raumwinkel ω₁, unter dem die Längsseiten 6 vom Leuchtpunkt 7 aus erscheinen. Insbesondere ist ω_{q} so klein, so daß ein Teil der in dem im Substrat liegenden Anteil des Lichtauskoppelkegels verlaufenden, auskoppelfähigen Lichtstrahlen auf die untere Abdeckschicht 4 trifft und nicht ausgekoppelt wird.

Zwar ist es grundsätzlich möglich, die Dicke des Substrates 3 soweit zu vergrößern, daß alle Lichtstrahlen innerhalb des Lichtaustrittskegels 8 auf die Querseiten 9 treffen. Dies ist jedoch aus praktischen Gründen nur eingeschränkt möglich. Denn die handelsüblichen Substrate 3 sind nur in bestimmten vorgegebenen Dicken erhältlich. Die Dicke des Substrates 3 kann daher nicht beliebig gewählt werden. Es ist daher von Vorteil, wenn die Längsseiten 6 möglichst lang gewählt werden. Die Querseiten 9 sollten ferner wenigstens so kurz gewählt werden, daß die von einem von einer Längsseite 6 am weitesten entfernt liegenden Leuchtpunkt ausgehenden Lichtstrahlen im Lichtaustrittskegel 8 unmittelbar auf diese Längsseite 6 treffen. Durch die Vergrößerung der Längsseiten 6 im Verhältnis zu den Querseiten 9 ergibt sich ein günstiges Verhältnis von Seitenflächen zu aktiver Fläche. Unter aktiver Fläche wird in diesem Zusammenhang die Fläche der aktiven Schicht 2 verstanden. Bei gleicher aktiver Fläche ist das Verhältnis von Seitenflächen zu aktiver Fläche bei einer ungleichen Länge der Längsseiten 6 und der Querseiten 9 größer als bei gleicher Länge der Längsseiten 6 und der Querseiten 9.

Die Tatsache, daß die innerhalb des in dem Substrat liegenden Anteils des Lichtaustrittskegels 8 verlaufenden Lichtstrahlen ungehindert auf die Längsseiten 6 treffen kann, und das günstige Verhältnis von Seitenflächen zu aktiver Fläche führt dazu, daß sich der Halbleiterchip 1 durch eine hohe Strombelastbarkeit bei gleichzeitig guter Strahlungsauskopplung aus-, zeichnet.

In den Figuren 2a und b sind jeweils ein Querschnitt und eine Aufsicht auf ein mit dem Halbleiterchip 1 ausgestattetes Lumineszenzdiodenbauelement 10 dargestellt. Die langgestreckten Halbleiterchips 1, bei denen das Verhältnis der Längen der Längsseiten zu den Längen der Querseiten wenigstens 10:1 beträgt, sind parallel nebeneinander angeordnet, so daß sich für die Lumineszenzdiode 10 insgesamt eine in etwa quadratische Grundfläche ergibt. Zwischen den Halbleiterchips 1 sind Trennwände 11 angeordnet. Die Halbleiterchips 1 und die Trennwände 11 sind von einer Fassung 12 umgeben. Sowohl die Halbleiterchips 1 als auch die Trennwände 11 und die Fassung 12 sind auf einem gemeinsamen Träger 13 angeordnet und von einem beispielsweise aus einem Kunststoff hergestellten Linsenkörper 14 abgedeckt.

Die Trennwände 11 und die Fassung 12 dienen dazu, die von den Halbleiterchips 1 in seitliche Richtung emittierte Strahlung vom Träger 13 weg in den Linsenkörper 14 umzulenken. Durch die Trennwände 11 wird insbesondere verhindert, daß die von einem der Halbleiterchips 1 emittierte Strahlung von einem der benachbarten Halbleiterchips 1 absorbiert wird.

In den Figuren 3a und 3b ist ein weiteres Ausführungsbeispiel eines Lumineszenzdiodenbauelements 5 dargestellt, bei dem der mittlere Halbleiterchip durch eine breite Trennwand 16 ersetzt ist, der auf seiner Oberseite eine Kontaktfläche 17 für Bonddrähte 18 aufweist. Die Bonddrähte 18 führen von der Kontaktfläche 17 zu Kontaktflächen 19 auf den Halbleiterchips 1.

Um die von den Halbleiterchips 1 emittierte Strahlung in eine vom Träger 13 abgewandte Emissionsrichtung zu konzentrieren, weist die Lumineszenzdiode 15 einen mit zwei linsenförmigen Ausbuchtungen 21 versehenen Linsenkörper 22 auf, der die Halbleiterchips 1 abdeckt.

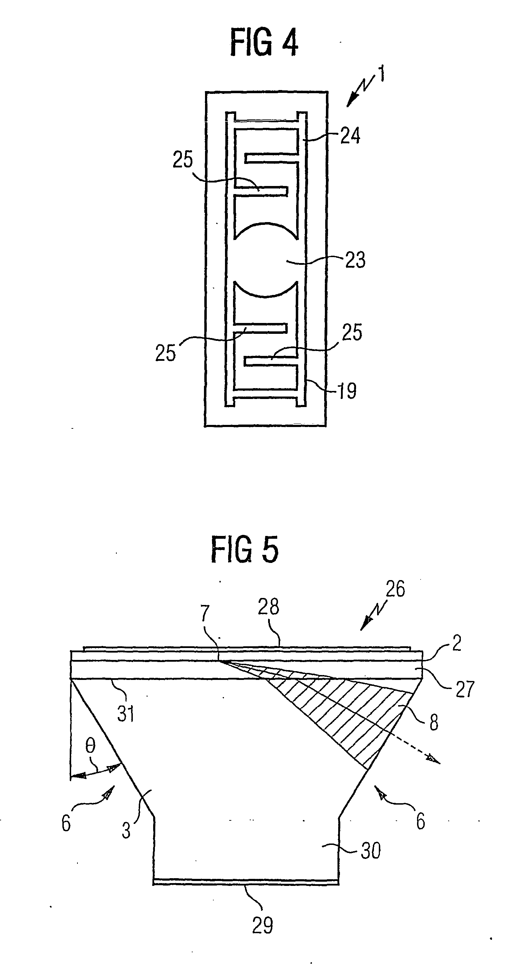

Figur 4 zeigt eine vergrößerte Aufsicht auf einen der in dem Lumineszenzdiodenbauelement 10 oder 15 verwendeten Halbleiterchips 1. Insbesondere erkennt man die detaillierte Struktur der Kontaktfläche 19. Die Kontaktfläche 19 weist eine zentrale Anschlußfläche 23, beispielsweise eine Bondfläche für eine Drahtverbindung, auf, von dem sich verzweigende Kontaktbahnen 24 mit Stichleitungen 25 ausgehen. Entlang dem Umfang des Halbleiterchips 1 sind die Kontaktbahnen 24 rahmenartig ausgebildet. Diese Ausbildung der Kontaktbahnen 24 gewährleistet eine gleichförmige Verteilung des Stroms über die aktive Schicht 2 hinweg. Durch die rahmenartige Ausbildung der Kontaktbahnen 24 entlang dem Umfang des Halbleiterchips 1 werden außerdem Potentialschwankungen vermieden.

In Figur 5 ist ein Querschnitt durch einen weiteren abgewandelten Halbleiterchip 26 dargestellt. Der Halbleiterchip 26 weist hier eine Mehrschichtstruktur 27 auf, die die aktive Schicht 2 umfaßt. Die Mehrschichtstruktur 27 ist auf ein strahlungsdurchlässiges Substrat 3 aufgebracht und wird auf der von dem Substrat 3 abgewandten Seite von einer oberen Elektrode 28 bedeckt. Dieser Elektrode 28 gegenüberliegend ist das Substrat mit einer unteren Elektrode 29 versehen.

Auf der an die Mehrschichtstruktur 27 angrenzenden Seite weist das Substrat 3 angeschrägte Seitenflächen 6 auf, die mit der Normale der Mehrschichtstruktur 27 einen Neigungswinkel θ einschließen. In Richtung der unteren Elektrode 29 gehen diese schräg stehenden Seitenflächen in senkrecht zur Mehrschichtstruktur 27 bzw. zur aktiven Schicht 2 angeordnete Seitenflächen über.

Bei einem Substrat, dessen Brechungsindex größer als der Brechungsindex der Mehrschichtstruktur ist, ist vorzugsweise der Neigungswinkel θ der angeschrägten Seitenflächen 6 des Substrats 3 größer als der kritische Winkel für eine von der Mehrschichtstruktur 27 und dem Substrat 3 gebildete Grenzfläche 31 (der Wert des kritischen Winkel ist gleich dem Wert des Totalreflexionswinkel für einen Übergang von dem Substrat 3 in die Mehrschichtstruktur 27). Durch diese Formgebung wird der Raumwinkel des Lichtaustrittskegels 8 wesentlich vergrößert. Daher wirkt sich auch bei dem in Figur 5 dargestellten Halbleiterchip 26 die Vergrößerung der Längsseiten 6 im Verhältnis zu den Querseiten 9 besonders vorteilhaft aus.

Die Mehrschichtstruktur kann beispielsweise eine auf GaN basierende Halbleiterstruktur sein. Als Halbleitermaterialien sind hierfür insbesondere GaN, AlGaN, InGaN, InAlGaN geeignet. Derartige Mehrschichtstrukturen werden in der Regel mittels eines Epitaxieverfahrens hergestellt.

Vorzugsweise wird bei der Erfindung die Mehrschichtstruktur 27 auf ein strahlungsdurchlässiges Substrat aufgewachsen, aus dem auch das Substrat 3 für den Halbleiterchip gefertigt wird. Als Epitaxiesubstrat eignet sich insbesondere ein SiC-Substrat, das sich durch seine Strahlungsdurchlässigkeit und elektrische Leitfähigkeit auszeichnet. Insbesondere ist der Brechungsindex von SiC größer als der Brechungsindex einer GaN-basierenden Mehrschichtstruktur. Damit tritt vorteilhafterweise keine Totalreflexion der in der aktiven Schicht erzeugten Strahlung beim Eintritt in das Substrat auf.

Der an die untere Elektrode 29 grenzende Bereich des Substrats 3 ist vorzugsweise würfel- oder quaderförmig gebildet. Durch diese Formgebung mit zueinander orthogonalen oder parallelen Begrenzungsflächen in diesem Bereich wird die Montage des Halbleiterchips erleichtert. Dies trifft in besonderem Maß auf automatische Bestückungsanlagen zu, die für die Montage herkömmlicher quader- oder würfelförmiger Chips ausgelegt sind.

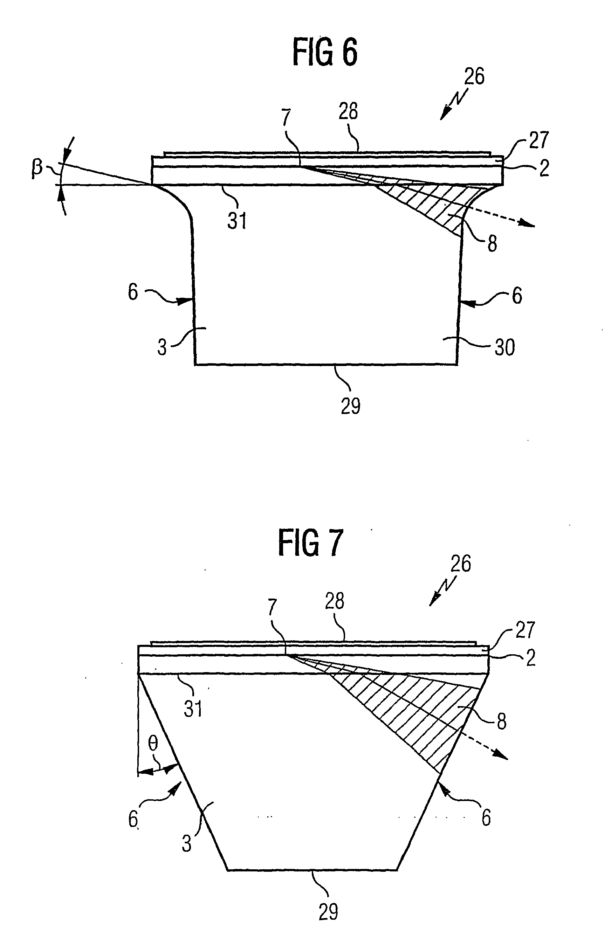

In Figur 6 und 7 sind weitere Ausführungsbeispiele der Erfindung dargestellt, die sich ebenfalls durch einen hohen Auskopplungsgrad aufgrund einer besonderen Formgebung des Substrats 3 auszeichnen. Bei dem in Figur 6 dargestellten Ausführungsbeispiel schließt das Substrat 3 zunächst einen spitzen Winkel β mit seinen Längsseiten gegenüber der Grenzfläche 31 ein. Im weiteren Verlauf schwenken die Längsseiten 6 zunehmend in Richtung auf die untere Elektrode 29 um. Die Seitenflächen 6 sind konkav ausgebildet und weisen einen fließenden Übergang zu einem vorzugsweise quader- oder würfelförmigen Stumpf 30 auf.

Bei dem in Figur 7 dargestellten Ausführungsbeispiel wurde schließlich auf die Ausbildung des Stumpfes 30 verzichtet. Das Substrat 3 verjüngt sich über die gesamte Dicke hinweg. Es sei angemerkt, daß es grundsätzlich auch möglich ist, die abgeschrägten Längsseiten 6 nach der Art einer Fresnel-Linse aus gegeneinander versetzt angeordneten Teilflächen zu bilden. In diesem Fall bleibt zumindest im Umriß der rechteckige Querschnitt des Halbleiterchips 1 gewahrt.

Ferner sei angemerkt, daß der Grundriß des Halbleiterchips 1 oder 26 nicht notwendigerweise rechteckförmig sein muß. Der Grundriß des Halbleiterchips 1 oder 26 kann auch die Form eines verkippten Parallelogramms, eines Trapez oder eines Mehrecks aufweisen.

Die Erhöhung der Lichtausbeute bei den Halbleiterchips 1 und 26 in Bezug auf einen herkömmlichen Chip mit quadratischem Grundriß wurde im einzelnen ermittelt. Dabei wurden folgende Ergebnisse erzielt:

### Beispiel 1:

Ein InGaN-Halbleiterchip weist eine aktive Fläche auf, die um den Faktor 4 vergrößert werden soll. Die Ergebnisse der Schätzung sind in Tabelle 1 enthalten. Dabei sind in den drei letzten Spalten jeweils die Anteile der ausgekoppelten Strahlung bezogen auf die Gesamtauskoppelung aus dem Standardchip angegeben.

**Tabelle 1:**

| Typ | Querschnittsfläche x Höhe | Strom | Vorderseite | Seiten flächen | Summe |
|---|---|---|---|---|---|
| Standardchip = Referenz | 250 x 250 µm² x 250 µm | 50 mA | 50 % | 50 % | 100 % |
| Groß-Chip | 750 x 750 µm² x 250 µm | 450 mA | 450 % | 150 % | 600 % |
| Rechteck-Chip | 250 x 2250 µm² x 250 µm | 450 mA | 450 % | 250 % | 700 % |

### Beispiel 2:

Für den in Figur 5 dargestellten Halbleiterchip 26 mit abgeschrägten Seiten ergaben sich für die verschiedenen Typen folgende in Tabelle 2 aufgeführte Werte. Dabei wurde der Anteil der ausgekoppelten Strahlung auf die in Tabelle 1 angegeben Gesamtauskoppelung beim Standardchip bezogen.

**Tabelle 2:**

| Typ | Querschnittsfläche x Höhe | Strom | Vorderseite | Seitenflächen | Summe |
|---|---|---|---|---|---|
| Standardchip | 250 x 250 µm² x 250 µm | 50 mA | 50 % | 150 % | 200 % |
| Groß-Chip | 750 x 750 µm² x 250 µm | 450 mA | 450 % | 400 % | 850 % |
| Rechteck-Chip | 250 x 2250 µm² x 250 µm | 450 mA | 450 % | 1100% | 1550% |

Gegenüber dem gleichflächigen Groß-Chip weist der Halbleiterchip 26 aus Figur 5 einen Verbesserungsfaktor von 1,8 auf, während der Gewinn bei dem in Figur 1a und 1b dargestellten Halbleiterchip 1 in etwa 15 % beträgt. Durch die Verlängerung der Längsseiten 6 gegenüber den Querseiten 9 läßt sich die Lichtausbeute somit deutlich steigern.

Es sei angemerkt, daß die hier vorgestellten Überlegungen auch für einen Halbleiterchip gelten, bei dem die aktive Schicht gleich lange Querseiten und Längsseiten aufweist und bei dem das Substrat eine langgestreckte Form aufweist. Dies bietet sich vor allem an, wenn die aktive Schicht selbst eine ausreichend gute Wärmeleitfähigkeit aufweist, um die in der aktiven Zone entstehende Verlustwärme abzuführen, und wenn das Substrat im Gegensatz dazu eine schlechte Wärmeleitfähigkeit aufweist und daher große Querschnittsflächen benötigt, um die Verlustwärme abführen zu können.

## Patentansprüche

1. Strahlungsemittierender Halbleiterchip (1,26) mit einer aktiven Schicht (2), die eine elektromagnetische Strahlung emittierende Zone umfasst, und einem für die Strahlung durchlässigen Substrat (3), auf dem eine die aktive Schicht (2) umfassende Mehrschichtstruktur (27) angeordnet ist, der Querseiten (9) und Längsseiten (6) aufweist, die den Halbleiterchip (1,26) in den Erstreckungsrichtungen der aktiven Schicht (2) seitlich begrenzen und durch die zumindest ein Teil der Strahlung ausgekoppelt wird, wobei die Querseiten (9) in Erstreckungsrichtung der aktiven Zone kürzer als die Längsseiten (6) sind,
**dadurch gekennzeichnet, daß**
die Querseiten (9) wenigstens derart kurz sind, dass die von einem von einer Längsseite (6) am weitesten entfernt liegenden Leuchtpunkt (7) der aktiven Schicht (2) unter einem Winkel kleiner als dern Totalreflexionswinkel ausgehenden Lichtstrahlen unmittelbar auf diese Längsseite (6) treffen.

2. Halbleiterchip nach Anspruch 1,
**dadurch gekennzeichnet, daß**
die Längsseiten (6) in Erstreckungsrichtung der aktiven Schicht (2) wenigstens doppelt so lang wie die Querseiten (9) sind.

3. Halbleiterchip nach einem der Ansprüche 1 oder 2,
**dadurch gekennzeichnet, daß**
die Längsseiten (6) in Erstreckungsrichtung der aktiven Schicht (2) wenigstens die zehnfache Länge der Querseiten (9) aufweisen.

4. Halbleiterchip nach einem der Ansprüche 1 bis 3,
**dadurch gekennzeichnet, daß**
das Substrat (3) als Parallelepiped ausgebildet ist.

5. Halbleiterchip nach einem der Ansprüche 1 bis 4,
**dadurch gekennzeichnet, daß**
sich das Substrat (3) zu einer der aktiven Schicht (2) gegenüberliegenden Grundfläche hin verjüngt.

6. Halbleiterchip nach Anspruch 5,
**dadurch gekennzeichnet, daß**
das Substrat (3) eine zur Erstreckungsrichtung der aktiven Schicht (2) schräge Seitenfläche aufweist, der zur Grundfläche hin eine zur Erstreckungsrichtung der aktiven Schicht (2) senkrechte Seitenfläche nachgeordnet ist.

7. Halbleiterchip nach einem der Ansprüche 1 bis 6,
**dadurch gekennzeichnet, daß**
auf einer seiner Oberflächen Stromaufweitungsstege (24) vorgesehen sind, die von einer Anschlußfläche (23) ausgehen.

8. Halbleiterchip nach Anspruch 7,
**dadurch gekennzeichnet, daß**
von den Stromaufweitungsstegen (24) Stichleitungen (25) abzweigen.

9. Halbleiterchip nach einem der Ansprüche 1 bis 8,
**dadurch gekennzeichnet, daß**
der Brechungsindex des Substrats (3) größer als der Brechungsindex der Mehrschichtstruktur (27) ist.

10. Halbleiterchip nach einem der Ansprüche 1 bis 9,
**dadurch gekennzeichnet, daß**
die Mehrschichtstruktur (27) GaN, InGaN, AlGaN oder InAlGaN enthält.

11. Halbleiterchip nach einem der Ansprüche 1 bis 10,
**dadurch gekennzeichnet, daß**
die aktive Schicht (2) GaN, InGaN, AlGaN oder InAlGaN enthält.

12. Halbleiterchip nach einem der Ansprüche 1 bis 11,
**dadurch gekennzeichnet, daß**
das Substrat ein SiC-Substrat (3) ist.

13. Halbleiterchip nach einem der Ansprüche 1 bis 12,
**dadurch gekennzeichnet, daß**
die Mehrschichtstruktur (27) epitaktisch hergestellt ist.

14. Halbleiterchip nach Anspruch 13,
**dadurch gekennzeichnet, daß**
das Substrat (3) aus einem zur epitaktischen Herstellung der Mehrschichtstruktur (27) verwendeten Epitaxiesubstrat gefertigt ist.

15. Lumineszenzdiode,
**dadurch gekennzeichnet, daß**
die Lumineszenzdiode (10,15) einen Halbleiterchip (1,26) nach einem der Ansprüche 1 bis 14 enthält.

16. Lumineszenzdiode nach Anspruch 15,
**dadurch gekennzeichnet, daß**
sich entlang der Längsseiten (6) des Halbleiterchips (1,26) Reflektoren (11) erstrecken.

## Claims

1. Radiation-emitting semiconductor chip (1, 26) having an active layer (2) which comprises a zone which emits electromagnetic radiation, and having a substrate (3) through which radiation can pass and on which a multilayer structure (27) is arranged which comprises the active layer (2), wherein the semiconductor chip (1, 16) has lateral faces (9) and longitudinal faces (6) which bound the semiconductor chip (1, 26) in the extent directions of the active layer (2) at the side and through which at least a portion of the radiation is output, wherein the lateral faces (9) are shorter in the extent direction of the active zone than the longitudinal faces (6),
**characterized in that**
the lateral faces (9) are at least sufficiently short that the light beams that originate from a light point (7) which is furthest away from a longitudinal face (6) in the active layer (2) at an angle less than the total-internal reflection angle directly strike this longitudinal face (6).

2. Semiconductor chip according to Claim 1,
**characterized in that**
the longitudinal faces (6) are at least twice as long in the extent direction of the active layer (2) as the lateral faces (9).

3. Semiconductor chip according to one of Claims 1 or 2,
**characterized in that**
the longitudinal faces (6) are at least ten times as long in the extent direction of the active layer (2) as the lateral faces (9).

4. Semiconductor chip according to one of Claims 1 to 3,
**characterized in that**
the substrate (3) is in the form of a parallelepiped.

5. Semiconductor chip according to one of Claims 1 to 4,
**characterized in that**
the substrate (3) tapers towards a base area which is opposite the active layer (2).

6. Semiconductor chip according to Claim 5,
**characterized in that**
the substrate (3) has a side surface which is inclined with respect to the extent direction of the active layer (2) and, towards the base surface, is followed by a side surface which is at right angles to the extent direction of the active layer (2).

7. Semiconductor chip according to one of Claims 1 to 6,
**characterized in that**
current widening webs (24), which originate from a connecting surface (23), are provided on one of the surfaces of the semiconductor chip.

8. Semiconductor chip according to Claim 7,
**characterized in that**
spur lines (25) branch off from the current widening webs (24).

9. Semiconductor chip according to one of Claims 1 to 8,
**characterized in that**
the refractive index of the substrate (3) is higher than the refractive index of the multilayer structure (27).

10. Semiconductor chip according to one of Claims 1 to 9,
**characterized in that**
the multilayer structure (27) contains GaN, InGaN, AlGaN or InAlGaN.

11. Semiconductor chip according to one of Claims 1 to 10,
**characterized in that**
the active layer (2) contains GaN, InGaN, AlGaN or InAlGaN.

12. Semiconductor chip according to one of Claims 1 to 11,
**characterized in that**
the substrate is a SiC substrate (3).

13. Semiconductor chip according to one of Claims 1 to 12,
**characterized in that**
the multilayer structure (27) is produced epitaxially.

14. Semiconductor chip according to Claim 13,
**characterized in that**
the substrate (3) is manufactured from an epitaxial substrate which is used for epitaxial production of the multilayer structure (27).

15. Light-emitting diode,
**characterized in that**
the light-emitting diode (10, 15) contains a semiconductor chip (1, 26) according to one of Claims 1 to 14.

16. Light-emitting diode according to Claim 15,
**characterized in that**
reflectors (11) extend along the longitudinal faces (6) of the semiconductor chip (1, 26).

## Revendications

1. Puce semi-conductrice (1, 26) émettant un rayonnement, qui présente
une couche active (2) qui comprend une zone qui émet un rayonnement électromagnétique et
un substrat (3) transparent au rayonnement, sur lequel est disposée une structure multicouche (27) qui comprend la couche active (8),
des côtés transversaux (9) et des côtés longitudinaux (6) qui délimitent latéralement la puce semi-conductrice (1, 26) dans les directions d'extension de la couche active (2) et par laquelle au moins une partie du rayonnement est émise,
les côtés transversaux (9) étant plus courts que les côtés longitudinaux (6) dans la direction d'extension de la zone active,
**caractérisée en ce que**
les côtés transversaux (9) sont plus courts au moins de telle sorte que les rayons lumineux émis sous un angle inférieur à l'angle de réflexion totale par le point lumineux (7) de la couche active (2) situé le plus loin d'un côté longitudinal (6) sont directement incidents sur ce côté longitudinal (6).

2. Puce semi-conductrice selon la revendication 1, **caractérisée en ce que** les côtés longitudinaux (6) ont au moins le double de la longueur des côtés transversaux (9) dans la direction d'extension de la couche active (2).

3. Puce semi-conductrice selon l'une des revendications 1 ou 2, **caractérisée en ce que** les côtés longitudinaux (6) ont au moins dix fois la longueur des côtés transversaux (9) dans la direction d'extension de la couche active (2).

4. Puce semi-conductrice selon l'une des revendications 1 à 3, **caractérisée en ce que** le substrat (3) est configuré comme parallélépipède.

5. Puce semi-conductrice selon l'une des revendications 1 à 4, **caractérisée en ce que** le substrat (3) se rétrécit en direction d'une surface de base opposée à la couche active (2).

6. Puce semi-conductrice selon la revendication 5, **caractérisée en ce que** le substrat (3) présente une surface latérale oblique par rapport à la direction d'extension de la couche active (2) et disposée en direction de la surface de base perpendiculairement à la direction d'extension de la couche active (2).

7. Puce semi-conductrice selon l'une des revendications 1 à 6, **caractérisée en ce qu'**une de ses surfaces présente des nervures (24) d'évasement de courant qui partent d'une surface de raccordement (23).

8. Puce semi-conductrice selon la revendication 7, **caractérisée en ce que** des conducteurs de prélèvement (25) sont dérivés des nervures (24) d'évasement de courant.

9. Puce semi-conductrice selon l'une des revendications 1 à 8, **caractérisée en ce que** l'indice de réfraction du substrat (3) est supérieur à l'indice de réfraction de la structure multicouche (27).

10. Puce semi-conductrice selon l'une des revendications 1 à 9, **caractérisée en ce que** la structure multicouche (27) contient du GaN, de l'InGaN, de l'AlGaN ou de l'InAlGaN.

11. Puce semi-conductrice selon l'une des revendications 1 à 10, **caractérisée en ce que** la couche active (2) contient du GaN, de l'InGaN, de l'AlGaN ou de l'InAlGaN.

12. Puce semi-conductrice selon l'une des revendications 1 à 11, **caractérisée en ce que** le substrat est un substrat (3) en SiC.

13. Puce semi-conductrice selon l'une des revendications 1 à 12, **caractérisée en ce que** la structure multicouche (27) est formée par épitaxie.

14. Puce semi-conductrice selon la revendication 13, **caractérisée en ce que** le substrat (3) est réalisé à partir d'un substrat d'épitaxie utilisé pour la formation de la structure multicouche (27) par épitaxie.

15. Diode luminescente **caractérisée en ce que** la diode luminescente (10, 15) contient une puce semi-conductrice (1, 26) selon l'une des revendications 1 à 14.

16. Diode luminescente selon la revendication 15, **caractérisée en ce que** des réflecteurs (11) s'étendent le long des côtés longitudinaux (6) de la puce semi-conductrice (1, 26).
